Europäisches Patentamt

European Patent Office

Office européen des brevets

(19)

(11) Numéro de publication : **0 000 317**
**B1**

(12) **FASCICULE DE BREVET EUROPÉEN**

(45) Date de publication du fascicule du brevet :
19.05.82

(51) Int. Cl.³ : **H 01 L 21/285, H 01 L 29/62**

(21) Numéro de dépôt : 78430003.0

(22) Date de dépôt : 22.06.78

(54) **Procédé de fabrication d'une électrode en siliciure sur un substrat notamment semi-conducteur.**

(30) Priorité : 30.06.77 US 811914

(43) Date de publication de la demande :
10.01.79 (Bulletin 79/01)

(45) Mention de la délivrance du brevet :
19.05.82 Bulletin 82/20

(84) Etats contractants désignés :
DE FR GB

(56) Documents cités :
FR - A - 2 250 198
FR - A - 2 325 192

JOURNAL OF APPLIED PHYSICS, vol. 47, decembre 1976, New York, J.O. OLOWOLAFE et ai. « Formation kinetics of CrSi₂ films on Si substrates with and without interposed Pd₂Si layer », pages 5 182-5 186

JOURNAL OF THE ELECTROCHEMICAL SOCIETY, vol. 112, juin 1965, Princeton, J.B. BERKOWITZ-MATTUCK « High-temperature oxidation », pages 583-389

(73) Titulaire : **International Business Machines Corporation**
**Armonk, N.Y. 10504 (US)**

(72) Inventeur : **Crowder, Billy Lee**
**Oscawana Lake Road**
**Putnam Valley New York 10579 (US)**
Inventeur : **Zirinsky, Stanley**
**750 Kappock Street**
**Bronx New York 10463 (US)**

(74) Mandataire : **Klein, Daniel**
**COMPAGNIE IBM FRANCE Département de Propriété Industrielle**
**F-06610 La Gaude (FR)**

Imprimerie Jouve, 18, rue St-Denis, 75001 Paris, France

# 0 000 317

Procédé de fabrication d'une électrode en siliciure sur un substrat notamment semi-conducteur

## Description

### Domaine de l'invention

La présente invention concerne un procédé de fabrication d'une électode en siliciure sur un substrat permettant de déposer un siliciure tel qu'un siliciure de molybdène, de tantale, de rhodium ou de tungstène sur le substrat, et notamment sur un substrat semi-conducteur constitué par du silicium dopé ou par du silicium polycristallin dopé.

### Etat de la technique antérieure

Le silicium polycristallin est très utilisé depuis quelques années comme matériau d'interconnexion dans les circuits intégrés. L'emploi de ce type de silicium est souhaitable car il est très stable à température élevée et se prête au dépôt chimique en phase vapeur du dioxyde de silicium, ou à sa croissance thermique. Des interconnexions en silicium polycristallin ont été utilisées dans divers types de circuits intégrés, notamment dans des ensembles de dispositifs à couplage de charges, dans des ensembles logiques et dans des ensembles de cellules de mémoire à un seul dispositif à effet de champ.

En revanche, le silicium polycristallin présente l'inconvénient d'offrir une résistance électrique relativement élevée. Les tentatives qui ont été faites jusqu'à présent pour améliorer la performance de certains circuits intégrés en réduisant les dimensions des dispositifs, n'ont pas été couronnées de succès car les chutes de tension qui produisent dans les interconnexions ne diminuent pas lorsqu'on diminue les niveaux de tension requis aux fins du fonctionnement des circuits. Il serait donc souhaitable de réduire la résistance de couche (ou de feuille) des interconnexions en silicium polycristallin afin d'augmenter la vitesse du circuit.

On a proposé de remplacer le silicium polycristallin par divers métaux réfractaires tels que le molybdène et le tungstène. Toutefois, ces métaux s'oxydent lors du dépôt chimique en phase vapeur du dioxyde de silicium, et comme ces oxydes sont beaucoup moins stables que le dioxyde de silicium, ils posent un problème de fiabilité du circuit intégré finalement. Afin de résoudre le problème que pose l'utilisation de tels métaux réfractaires utilisés seuls, on a proposé de remplacer une partie de la couche de silicium polycristallin par une couche d'un siliciure de certains métaux. Par exemple, l'article de Rideout intitulé « Reducing the Sheet Resistance of Polysilicon Lines in Integrated Circuits » paru dans la publication «IBM Technical Disclosure Bulletin », Volume 17, n° 6, Novembre 1974, pages 18 311 833, suggère l'emploi d'un siliciure de hafnium obtenu en déposant du hafnium sur du silicium polycristallin, puis en chauffant l'ensemble pour faire réagir le hafnium et le silicium polycristallin. Le même article suggère également l'emploi à cette fin des siliciures de tantale, de tungstène ou de molybdène ; les bandes pouvant ensuite être recouvertes d'oxyde déposé chimiquement en phase vapeur.

Par ailleurs, un procédé connu (brevet des E.U.A. N° 3 381 182 et analogue à celui qui vient d'être mentionné permet de procéder au dépôt chimique en phase vapeur d'un siliciure de molybdène sur du silicium polycristallin par la réduction, d'un mélange de chlorure de molybdène et de silane, par de l'hydrogène. D'autres procédés permettant de réaliser divers siliciures et notamment un siliciure de tungstène en pulvérisant du tungstène sur un substrat contenant du silicium, puis en chauffant l'ensemble pour provoquer la formation du siliciure, sont décrits dans le brevet français N° 2 250 198 et dans l'article de V. Kumar intitulé « Fabrication and Thermal Stability de W-Si Ohmic Contacts » paru dans la publication « Journal of the Electrochemical Society, Solid-State Science and Technology », Février 1975, pages 262 à 269.

Toutefois, les techniques de pulvérisation proposées présentent un certain nombre d'inconvénients. En particulier, il est difficile de faire varier avec précision la composition de siliciure. D'autre part, lors de l'emploi de techniques de pulvérisation, il est nécessaire de procéder à un décapage pour retirer le métal de certaines régions où on ne doit pas former de siliciure.

### Exposé de la présente invention

L'un des objets de la présente invention est donc de fournir un procédé permettant de réaliser des siliciures de certains métaux réfractaires qui permette de commander et de faire varier avec précision la composition du siliciure ainsi réalisé.

Un autre objet de l'invention est de fournir un procédé permettant de retirer le siliciure de certaines parties désirées du substrat en utilisant de simples techniques de décapage faisant appel à l'emploi d'un solvant, sans qu'il y ait lieu d'avoir recours à des techniques de décapage plus complexes qui nécessitent un masquage.

La présente invention permet de former une couche d'un siliciure sur un substrat, le métal employé pouvant être du molybdène, du tantale, du tungstène, du rhodium ou des combinaisons de ces matériaux.

Le siliciure métallique est obtenu en procédant au dépôt par évaporation simultanée du silicium et de l'un desdits métaux sur le substrat désiré, puis en soumettant l'ensemble à un traitement thermique.

Par ailleurs, du dioxyde de silicium peut être obtenu à partir de la couche de siliciure par oxydation thermique de celle-ci à température élevée. Ce que l'on sait des propriétés des siliciures dans la masse, c'est-à-dire dans le volume ne permet pas de supposer que l'on pourrait obtenir par oxydation thermique des couches d'oxyde d'une épaisseur suffisante pour pouvoir être employées dans des circuits intégrés. Par exemple, le siliciure de molybdène et le siliciure de tungstène quand ils constituent une masse ou un volume sont connus pour leur excellente résistance à l'oxydation. A cet égard, on se reportera utilement aux comptes-rendus de la « Fourth International Chemical Vapor Deposition Conference », publiés par l'« Electrochemical Society », Princeton N.J. (U.S.A.) 1974 pour l'article de Lo et al. intitulé « A CVD Study of the Tungsten-Silicon System ». On pourra également se reporter à l'ouvrage « Engineering Properties of Selected Ceramic Materials », paru dans la publication « The American Ceramic Society, Inc... », Colombus Ohio (U.S.A.) 1966. En ce qui concerne notamment le di-siliciure de molybdène, on a pu déterminer qu'une couche d'oxyde d'une épaisseur de 10 microns pourrait être obtenues en 60 minutes à 1 050 °C en fonction de la quantité d'oxygène utilisée pour la formation du film. Une telle épaisseur conviendrait plus à des applications aérospatiales qu'à des applications aux circuits intégrés.

D'autres objets, caractéristiques et avantages de la présente invention ressortiront mieux de l'exposé qui suit, fait en référence aux dessins annexés à ce texte, qui représentent un mode de réalisation préféré de celle-ci.

## Brève description des dessins

Les figures 1A et 1B représentent schématiquement différentes étapes de la réalisation de circuits intégrés au moyen du procédé de la présente invention.

Les figures 2A à 2C représentent schématiquement les étapes d'une autre réalisation d'un circuit intégré au moyen du procédé de la présente invention.

Les figures 3A et 4A illustrent la relation qui existe entre la température et le temps d'oxydation, d'une part, et l'épaisseur d'une couche d'oxyde obtenue dans les cas du $WSi_2$ et $MoSi_2$ respectivement, d'autre part.

Les figures 3B et 4B illustrent la relation qui existe entre le temps d'oxydation et la température, d'une part, et la résistance de couche dans les cas du $WSi_2$ et du $MoSi_2$ respectivement, d'autre part.

## Description des modes préférés de réalisation de la présente invention

Le procédé de la présente invention peut être utilisé pour former des films du siliciure désiré sur n'importe quel substrat capable de résister aux températures élevées mises en œuvre durant le procédé de dépôt par évaporation simultanée et suffisamment adhérent audit siliciure. Le présent procédé peut être avantageusement employé aux fins de la réalisation de circuits intégrés et, de ce fait, présente un intérêt particulier lorsque le substrat est en silicium ou en silicium polycristallin. Par exemple, le présent procédé se prête particulièrement bien, à la réalisation de couches destinées à recouvrir des électrodes de porte en silicium polycristallin dopé, au remplacement du silicium polycristallin en tant que matériau constituant de telles électrodes, et enfin à la formation de couches recouvrant directement des bandes diffusées en silicium dopé.

Les siliciures métalliques auxquels s'adresse la présente invention sont le siliciure de molybdène et/ou le siliciure de tantale et/ou le siliciure de tungstène et/ou le siliciure de rhodium. Les métaux préférés pour constituer ces siliciures comprennent le molybdène, le tantale et le tungstène, et plus particulièrement encore ce dernier. En général, les siliciures métalliques comportent approximativement de 60 à 25 % en poids atomique du métal.

Selon la présente invention, le métal et le silicium sont vaporisés sous un vide poussé et déposés simultanément sur le substrat. Le vide employé est de l'ordre de $10^{-5}$ à $10^{-7}$ torr. Dans le procédé d'évaporation sous vide, le métal et le silicium sont chauffés sous un vide poussé et portés à une température suffisante pour provoquer leur évaporation. On utilise de préférence à cette fin un évaporateur à faisceau électronique et l'on utilise de préférence un canon à faisceau électronique pour le silicium et un autre canon pour le métal en raison du fait que l'évaporation de ces matériaux se produit à des vitesses différentes. L'emploi dudit évaporateur nécessite l'utilisation, comme source de chaleur, de la chaleur qui est dissipée lorsqu'un faisceau d'électrons fortement collimaté frappe le matériau. Les dispositifs et les techniques utilisés aux fins de l'évaporation du silicium et du métal sont bien connus et n'ont donc pas à être décrits ici de façon détaillée. De préférence, l'évaporation du métal et du silicium doit avoir lieu à raison de 25 à 50 Angstroms environ par seconde. Le substrat que l'on désire recouvrir est en général maintenu à une température comprise entre la température ambiante et 400 °C environ, et de préférence entre 150 °C et 250 °C environ lors du dépôt du métal et du silicium.

Une fois que la quantité désirée de métal et de silicium a été déposée sur le substrat, ce dernier est retiré de l'appareil utilisé aux fins de l'évaporation sous vide, puis chauffé dans une atmosphère inerte à des températures variant entre 700 °C et 1 100 °C environ et de préférence entre 900 °C et 1 100 °C. La température maximum convenable est essentiellement fonction de considérations pratiques et, en particulier, est choisie de manière à éviter une formation excessive de grains dans la couche de siliciure. Les atmosphères inertes convenables dans lesquelles le traitement thermique peut être effectué comprennent l'argon, l'hélium et l'hydrogène.

L'atmosphère inerte ne doit pas comporter la vapeur d'eau, d'oxygène, de composés à base de carbone, d'azote ou d'autres substances qui pourraient provoquer la formation de carbure, d'oxyde ou de nitrure pendant le traitement thermique.

Le substrat est chauffé aux températures ci-dessus pendant un intervalle de temps suffisant pour provoquer une réaction du métal et du silicium déposé sur celui-ci de manière à former le siliciure désiré. Cet intervalle de temps varie généralement entre 15 minutes et 2 heures environ, et il est inversement fonction de la température utilisée.

Après le traitement thermique, le substrat recouvert de la couche de siliciure peut éventuellement faire l'objet d'une oxydation de manière à recouvrir ladite couche d'oxyde d'auto-passivation. On a constaté que la diminution de la conductivité de la couche de siliciure qui résultait de l'oxydation était très inférieure à celle qui aurait dû théoriquement résulter de l'oxydation d'une partie déterminée de la couche. Par exemple, une oxydation de 50 % de la couche n'entraîne pas une diminution correspondante de 50 % de sa conductivité. Ce résultat serait dû à une oxydation préférentielle du silicium contenu dans la couche de siliciure et à une rétrodiffusion du métal, provoquant ainsi la formation d'une couche de siliciure enrichie en métal au-dessous de la couche oxydée. A cet égard, on se reportera utilement à l'article de J. Berkowitz-Matluck et al, intitulé « High Temperature Oxidation II. Molybdenum Silicide » paru dans la publication « J. Electrochemical Soc. » Vol. 112, N° 6, page 583, Juin 1965.

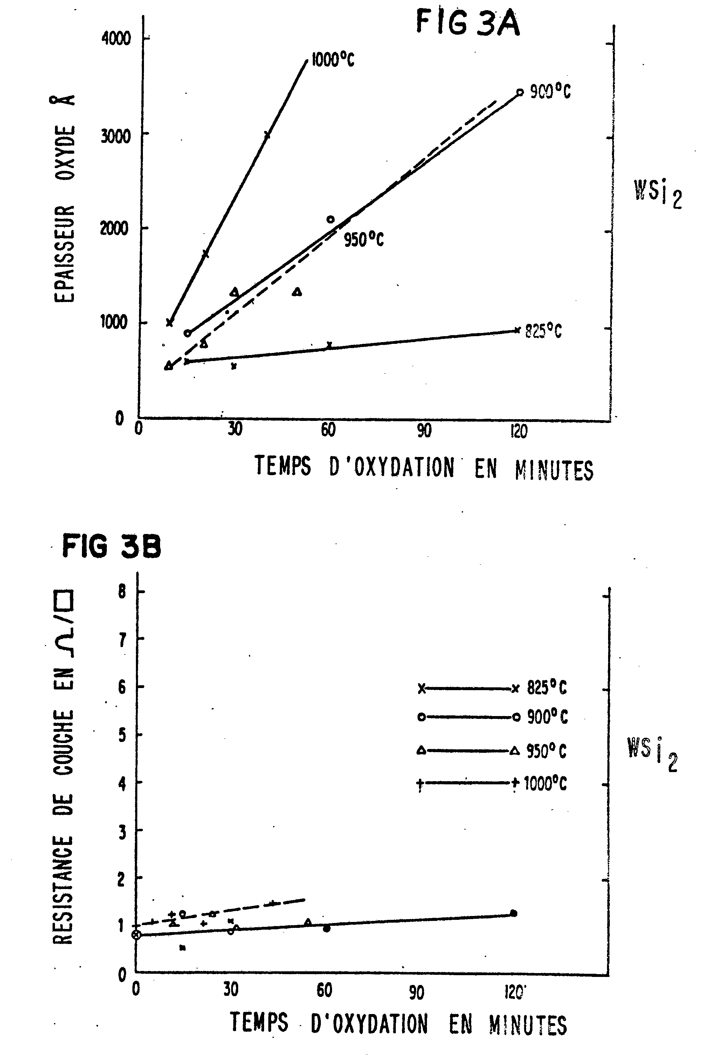

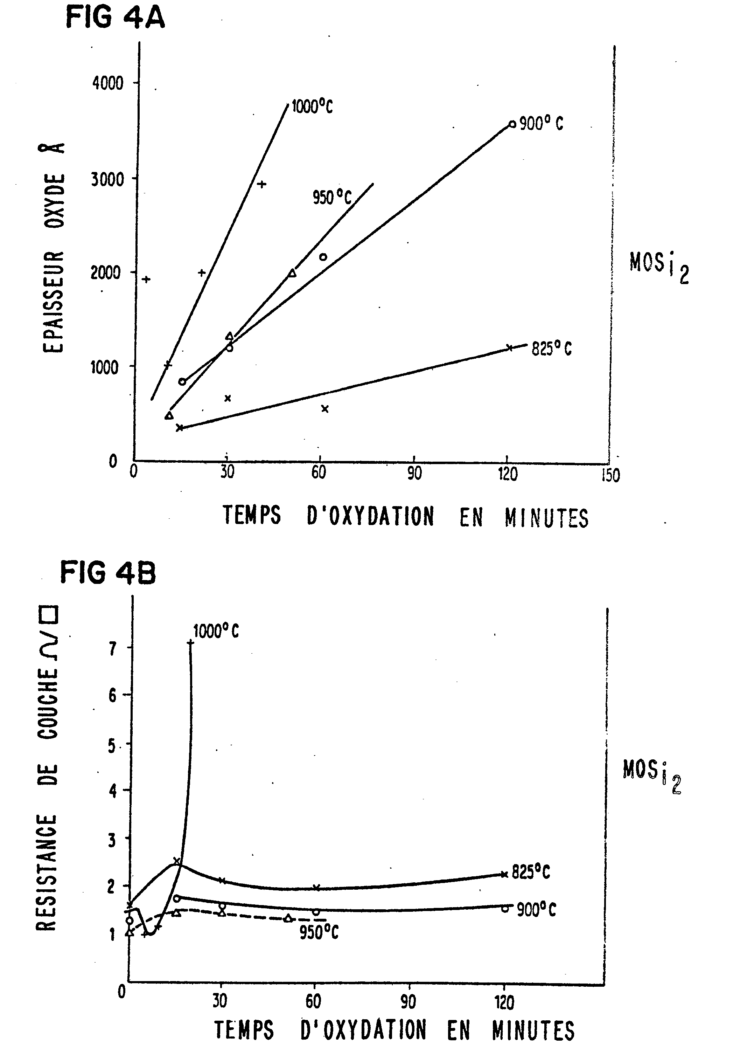

Les figures 3B et 4B montrent les variations de la résistivité de certains siliciures oxydés selon les températures. Les résultats d'ensemble indiquent qu'une amélioration de 30 % environ de la conductivité est obtenue par rapport à la conductivité théorique correspondant au pourcentage oxydé de la couche. L'oxydation du siliciure de molybdène à 1 000 °C pendant plus de 15 minutes a eu un effet nuisible sur la couche et modifié les propriétés de celle-ci. Il conviendrait donc d'éviter de telles conditions dans le cas du siliciure de molybdène afin que sa conductivité reste élevée. L'oxydation a été effectuée en phase vapeur dans les conditions spécifiées.

Le procédé préféré d'oxydation est une oxydation humide (vapeur d'eau) ou une oxydation sèche-humide-sèche. Ce procédé permet en effet d'obtenir des meilleurs résultats en termes de claquage que les autres techniques. L'oxydation en phase vapeur doit de préférence être effectuée à des températures variant entre 800 °C et 1 100 °C environ à une pression correspondant à peu après à la pression atmosphérique. La durée de l'oxydation est fonction de l'épaisseur de la couche d'oxyde que l'on désire obtenir et varie généralement entre 15 minutes et 2 heures environ. Par exemple, l'obtention d'une épaisseur voisine ou supérieure à 1 000 Angstroms nécessite plus de 2 heures à environ 800 °C et 30 minutes environ à 950 °C environ.

Les figures 3A et 4A montrent la croissance de l'oxyde isolant sur le siliciure pendant l'exposition à la vapeur aux températures et pendant les intervalles de temps indiqués.

Le tableau I en annexe indique les valeurs mesurées de la résistance de film de siliciure réalisé conformément à la présente invention par évaporation au moyen d'un faisceau électronique. Les films déposés sur le substrat de silicium avaient une épaisseur d'environ 0,5 micron.

Le tableau II en annexe permet de constater la conductivité améliorée du siliciure réalisé conformément au moyen du procédé de la présente invention comparée à celle du silicium dopé. Cette meilleure conductivité joue un rôle important en ce qui concerne l'augmentation de la vitesse de transmission des signaux sur une ligne de transmission.

Le tableau III en annexe montre que l'emploi du siliciure métallique réalisé conformément à la présente invention donne des résultats au moins aussi satisfaisants que ceux obtenus avec le silicium polycristallin, compte tenu de la tension de bande plate et de la tension de claquage électrique dans le cas où l'oxyde recouvre le siliciure. La tension de bande plate est l'un parmi les paramètres qui sont directement reliés à la tension de commande de porte nécessaire pour faire conduire le transistor à effet de champ (FET) et sa spécification limitée à une plage étroite est un facteur important du fonctionnement des transistors FET utilisés dans les circuits intégrés.

Par ailleurs, on a constaté que le champ de claquage moyen dans le cas d'un siliciure auto-oxydé d'une épaisseur d'environ 3 000 Angstroms disposé entre un conducteur d'aluminium et la couche de siliciure était supérieure à 2 à 3 mV/cm.

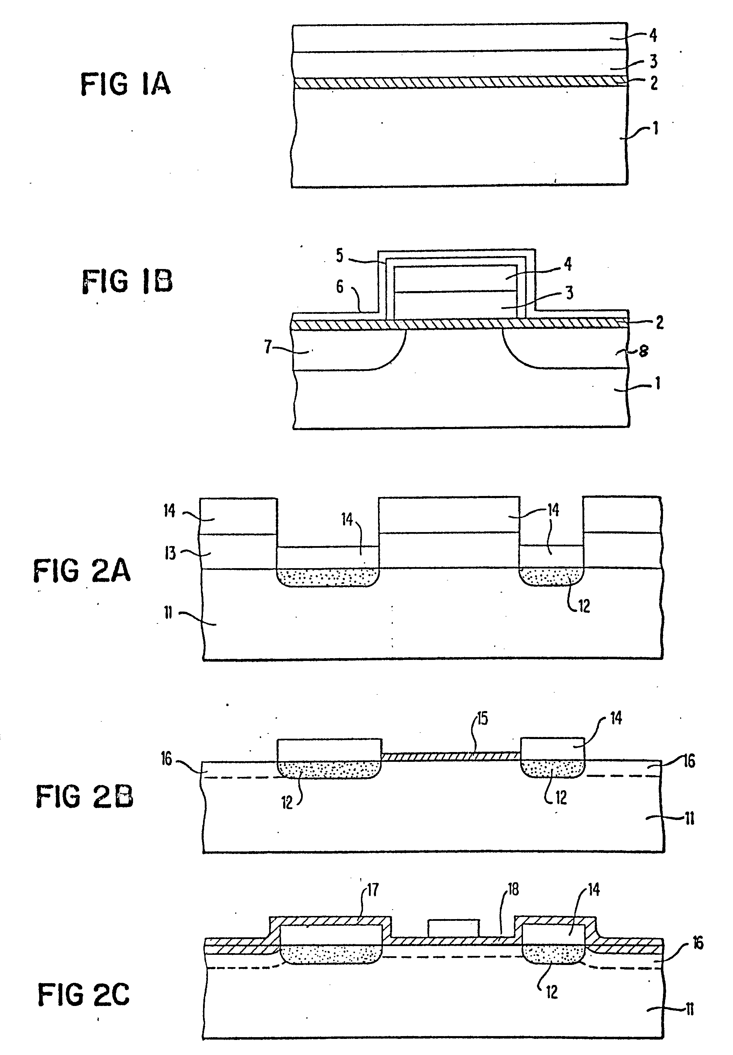

Les figures 1A et 1B montrent l'une des façons dont la présente invention peut être utilisée dans des circuits intégrés (par exemple aux fins de la formation d'une porte composite en silicium polycristallin et en siliciure métallique).

Pour faciliter la description des étapes du procédé de fabrication, on supposera que le substrat est du silicium de type p et que les impuretés diffusées ou implantées sont du type n, ce qui conduit à l'obtention d'un FET (Transistor à effet de champ) à canal n. En utilisant un substrat de type n et des impuretés de type p, on obtiendrait évidemment un FET à canal p.

D'autre part, la présente invention peut s'appliquer également à un substrat constitué par un matériau autre que le silicium. Les expressions « bande d'interconnexion de type métallique » et « bande d'interconnexion de conductivité élevée » employées ci-après se rapportent à des bandes d'un métal tel que l'aluminium ainsi qu'à des matériaux non métalliques qui peuvent néanmoins présenter une conductivité comparable.

Les références faites ci-après à des impuretés d'un « premier type » et d'un « second type » signifient par exemple que, si le « premier type » est p, le second « second type » est n, et inversement.

On a représenté sur les figures 1A et 1B une partie d'un substrat en silicium 1 de type p présentant une orientation cristalline désirée (par exemple < 100 >) et réalisé en découpant et en polissant une boule ou un barreau de silicium de type p (c'est-à-dire en présence d'un dopant du type p tel que le bore) conformément à des techniques classiques. D'autres dopants de type p utilisables avec le silicium sont l'aluminium, le gallium et l'indium.

On fait ensuite croître ou l'on dépose un isolant de porte constitué par une mince couche de dioxyde de silicium 2. Cette couche, dont l'épaisseur est généralement comprise entre 200 et 1 000 Angstroms est de préférence formée par oxydation thermique de la surface de silicium à 1 000 °C en présence d'oxygène sec.

On procède ensuite au dépôt d'une couche de silicium polycristallin 3. Cette couche a généralement une épaisseur variant entre 500 et 2 000 Angstroms environ et peut être réalisée par dépôt chimique en phase vapeur. On dope ensuite par dépôt chimique en phase vapeur. On dope ensuite cette couche au moyen d'un dopant de type n tel que l'arsenic, le phosphore ou l'antimoine, en utilisant une technique classique. Par exemple, on peut doper cette couche avec du phosphore en utilisant la technique qui consiste à déposer une couche de $POCl_3$ et en la chauffant à 1 000 °C environ de manière à introduire le phosphore dans la couche 3, qui devient alors de type n. On retire ensuite le résidu de la couche de $POCl_3$ en décapant la pastille dans de l'acide fluorhydrique tamponné. Une couche de siliciure 4 d'une épaisseur d'environ 2 000 à 4 000 Angstroms est ensuite formée sur la couche 3 en utilisant le procédé de la présente invention et décrit ci-dessus.

Une configuration de porte peut être réalisée en utilisant pour la lithographie une technique connue quelconque, par exemple le décapage chimique, le décapage dans un plasma, le décapage par ions réactifs, etc... Les techniques susceptibles d'être utilisées à cette fin varient dans leurs détails, mais permettent toutes d'obtenir une couche composite, siliciure/silicium polycristallin, présentant une configuration déterminée. Dans le cas d'un décapage chimique, on a constaté que du $H_3PO_4$ chaud permettait de décaper de façon sélective les siliciures par rapport au silicium polycristallin ou au $SiO_2$. Les siliciures doivent de préférence être décapés au moyen d'une technique dite « sèche » telle que la technique de décapage par ions réactifs faisant appel à l'emploi d'un matériau tel que le $CF_4$.

Les régions de source et de drain de type n sont ensuite formées au moyen des techniques bien connues d'implantation ou de diffusion ionique. Par exemple, des régions de source et de drain 7 et 8 de type n, respectivement, d'une profondeur de 2 000 Angstroms peuvent être réalisées par implantation d'$As^{75}$ en utilisant une énergie d'environ 100 KeV et une dose de $4 \times 10^{15}$ atomes/cm². Pendant l'implantation, la couche en silicium polycristallin 3 et la couche de siliciure 4 font fonction de masque et empêchent les impuretés de type n de pénétrer dans la région du canal du FET qui se trouve au-dessous de la couche 3.

Les limites entre les régions de source et de drain de type n et donc le canal du FET sont déterminées par les dimensions de la porte en silicium polycristallin. Cette technique est généralement dite technique de « porte auto-alignée ».

Une couche de dioxyde de silicium de passivation autoformée 5 est ensuite formée in situ sur les régions de porte au moyen des techniques d'oxydation précédemment décrites. Par exemple, l'ensemble fait l'objet d'une oxydation en phase vapeur à 950 °C environ pendant 30 minutes environ pour obtenir une épaisseur d'oxyde également supérieure à 1 000 et 3 000 Angstroms qui dépend bien sur du métal choisi comme on l'a vu ci-dessus.

On procède ensuite au dépôt chimique en phase vapeur d'une couche de dioxyde de silicium 6 d'une épaisseur d'environ 1 000 à 1 500 Angstroms pour prévenir toute inter-action entre la couche de siliciure et une interconnexion métallique, par exemple, en aluminium, qui serait ultérieurement appliquée. Les couches d'oxyde et les couches métalliques sont définies au moyen de techniques classiques de masquage et de décapage. Par exemple, le dioxyde de silicium peut être retiré en utilisant de l'acide fluorhydrique tamponné et l'aluminium peut être décapé au moyen d'un mélange d'acide phosphorique et d'acide nitrique. L'aluminium peut être déposé par pulvérisation ou par évaporation. La structure obtenue finalement est représentée sur la figure 1B.

Les figures 2A à 2C illustrent une autre utilisation de la présente invention aux fins de la fabrication de circuits intégrés. La technique ci-après est particulièrement avantageuse parce qu'elle offre la possibilité de retirer le siliciure déposé de régions prédéterminées du substrat, en utilisant des techniques d'élimination par décollement (lift off).

Le substrat 11 est recouvert d'une couche d'un matériau 13 qui permet d'obtenir une configuration convenable en vue de l'étape de décollement. Dans le cas le plus simple, le matériau constituant la couche 13 est un matériau résistant sensible au rayonnement dans lequel la configuration désirée est engendrée au moyen de techniques classiques (par exemple au moyen d'un électron résist du type PMMA avec un appareil de masquage à faisceau électronique). On notera que la couche 13 pourrait être constitué par plusieurs couches de matériaux sensibles, de façon à obtenir la géométrie de décollement désirée dans le cas de matériaux seulement capables de résister à des températures de traitements modérément élevées.

5

Une fois que la configuration désirée de la couche 13 a été obtenue, le substrat est dopé dans les régions qui ne sont pas protégées par le masque de manière à former régions 12 de type n par exemple des régions de source et de drain d'un FET. Des techniques telles que l'implantation ionique d'As, de P ou de Sb peuvent être employées aux fins du dopage de cette région.

Une couche 14 de métal et de silicium est déposée sur le substrat au moyen de l'étape d'évaporation simultanée précédemment décrite. La couche 14 n'est pas continue, c'est-à-dire qu'il n'y a pas de liaisons entre les régions qui se trouvent au-dessus du masque et celles qui ne le sont pas, comme cela se produirait dans le cas de l'emploi d'une technique de pulvérisation, car cette dernière provoquerait un recouvrement des bords qui pourrait entraîner une telle liaison ou interconnexion. Le matériau constituant le masque et celui qui le recouvre peuvent donc être aisément retirés au moyen d'une simple technique de décollement en utilisant un solvant tel que l'acétone qui élimine le matériau résistant qui subsistait pour former ledit masque.

L'ensemble est ensuite soumis à un traitement thermique à des températures variant entre 700 et 1 100 °C environ dans une atmosphère inerte telle que de l'argon, de l'hydrogène ou de l'hélium, comme l'exige la présente invention, pour former le siliciure. La couche de siliciure 14 pourra ensuite être oxydée de manière à être recouverte d'une couche d'oxyde de passivation.

Un masque composite 15 tel qu'une couche de nitrure de silicium déposée au-dessus d'une couche de dioxyde de silicium, est disposé au-dessus de la région de canal du dispositif FET, afin de servir comme masque empêchant ou bloquant toute oxydation du substrat à cet emplacement.

Des impuretés de dopage 16 telles que des atomes de bore peuvent être introduites au moyen de techniques d'implantation ionique, dans les régions de champ. On fait croître ensuite une couche 17 de dioxyde de silicium, par exemple, par dépôt chimique en phase vapeur, sur les parties du substrat qui ne sont pas protégées par le masque 15.

Le masque composite de blocage d'oxydation est ensuite retiré au moyen d'un solvant approprié. Si, par exemple, on utilise du nitrure de silicium, celui-ci peut être décapé dans une solution d'acide phosphorique à 180 °C. Le dioxyde de silicium peut être décapé dans une solution d'acide fluorhydrique tamponné.

On fait ensuite croître sur le substrat un isolant de porte en dioxyde de silicium 18. Le dopage de la région du canal, si nécessaire, est effectué par une implantation ionique. On procède ensuite au dépôt du matériau constituant la porte, puis à sa délimitation selon une configuration désirée au moyen des techniques connues de masquage et de décapage. Ce matériau peut être obtenu par évaporation simultanée et chauffage du silicium et du métal, par dépôt de silicium polycristallin seul, ou par dépôt du silicium polycristallin et d'une couche formée par évaporation simultanée et chauffage du silicium et du métal conformément aux techniques de la présente invention.

Bien que l'on ait décrit dans ce qui précède et représenté sur les dessins les caractéristiques essentielles de la présente invention appliquées à un mode de réalisation préféré de celle-ci, il est évident que l'homme de l'art peut y apporter toutes modifications de forme ou de détail qu'il juge utiles, sans pour autant sortir du cadre de ladite invention.

TABLEAU I

Résistance du siliciure en fonction de sa composition et du traitement thermique employé (dépôt par faisceau électronique) (films de 0,5 μ)

| Composition | | Résistance dans le corps (μΩ/cm) selon art antérieur | Avant traitement thermique | | Substrat Si oxydé Après traitement thermique (1 000 °C — 20 min. H₂) | |
|---|---|---|---|---|---|---|
| | | | Résistance dans le volume du corps (μΩ/cm) | Résistance de couche (Ω/□) | Résistance dans le volume du corps (μΩ/cm) | Résistance de couche (Ω/□) |
| W-Si | | | | | | |
| %W | Composition | | | | | |
| 92 | W₅Si₃ | 30 | 210 | 4,2 | 55 | 1,09 |
| 76,5 | WSi₂ | 33 | 370 | 7,4 | 54 | 1,07 |
| 62 | WSi₂ + Si | --- | 150 | 30 | 86 | 1,72 |
| Ta-Si | | | | | | |

TABLEAU I (Suite)

| Composition | Résistance dans le corps (μΩ/cm) selon art antérieur | Avant traitement thermique | | Substrat Si oxydé Après traitement thermique (1 000 °C — 20 min. $H_2$) | |
|---|---|---|---|---|---|
| | | Résistance dans le volume du corps (μΩ/cm) | Résistance de couche (Ω/□) | Résistance dans le volume du corps (μΩ/cm) | Résistance de couche (Ω/□) |
| %Ta Composition | | | | | |
| 92 Ta$_5$Si$_3$ | 8 | 300 | 6,0 | 72,5 | 1,45 |
| 76 TaSi$_2$ | 8,5 | 372 | 7,5 | 79 | 1,58 |
| 62 TaSi$_2$ + Si | --- | 900 | 18,0 | 166 | 8,3 |
| Mo-Si | | | | | |
| %Mo Composition | | | | | |
| 85 Mo$_5$-Si$_3$ | 18 | 250 | 5,0 | 60 | 1,2 |
| 63 MoSi$_2$ | 22 | 325 | 6,5 | 70 | 1,4 |
| 50 MoSi$_2$ + Si | --- | 800 | 16,0 | 159 | 3,0 |
| Rh-Si | | | | | |
| %Rh Composition | | | | | |
| 78,7 RhSi | 155* | 175 | 3,5 | 77,5 | 1,55 |

\* Film interdiffusé
(cf. Petersson, « Phys. Stat. Sol » (a) 36, 217 (1976)

TABLEAU II
Résistances de couche obtenues pour différents cycles de traitement
(en Ω/□)

| | Bande de siliciure (siliciure de tungstène) (/) | Bande diffusée (silicium dopé au phosphore) (/) |
|---|---|---|
| FET (en simulation) | | |
| Echantillon 1 | 2,0 ± 0,1 | — |
| FET | | |
| Echantillon 2 | 2,87 ± 0,04 | 19,7 ± 0,4 |
| Echantillon 3 | 2,73 ± 0,10 | 20,3 ± 2 |

20 à 90 emplacements de test
4 points de test par emplacement.

TABLEAU III
Résumé des données obtenues au moyen de la technique qui met en œuvre des condensateurs
(254 microns)$^2$

| | $V_{fb}$(volts) | $N_{avg}$(cm$^{-3}$) | $t_{ox}$(Å) | $V_{bd}$(volts) | $E_{bf}$(M volts/cm) |
|---|---|---|---|---|---|
| FET simulé échantillon MoSi$_2$ | − 1,11 ± 0,04 | --- | 323 | --- | --- |
| FET Echantillon 2 - WSi$_2$ | − 1,07 ± 0,03 | 1,5 × 10$^{16}$ | 376 | 26 ± 8 | 7 |
| Echantillon 3 WSi$_2$ | − 1,1 ± 0,1 | 1,6 × 10$^{16}$ | 375 | 32 ± 7 | 8,6 |
| Echantillon 4 WSi$_2$ | --- | --- | 370 | 29 ± 7 | 7,8 |
| Echantillon 5 (Contrôle) | − 1,1* | --- | 375 | 16,5 ± 14 | 4,4 |

* Valeur prévue pour une porte de commande FET en silicium polycristallin,

$V_{fb}$ = tension de bande plate,

$N_{avg}$ = dopage moyen de surface,

$t_{ox}$ = épaisseur de l'oxyde de la porte,

$V_{bd}$ = tension de claquage pour l'oxyde de porte (valeur moyenne pour 100 condensateurs dans les conditions opératoires déterminées),

$E_{bf}$ = champ électrique de claquage,

$V_{fb}$ et $N_{avg}$ ont été déterminés à partir de mesures sur les caractéristiques C (V),

M volts = volts × $10^6$.

Les résultats indiqués (à l'exception de ceux relatifs à $V_{bd}$) ont été obtenus au moyen de 20 à 90 emplacements de test par pastille.

**Revendications**

1. Procédé de fabrication d'une électrode en siliciure sur un substrat, consistant à déposer un métal réfractaire et du silicium sur le substrat, caractérisé en ce qu'il comporte les étapes suivantes :

vaporisation simultanée du métal et du silicium à partir d'une source de métal et d'une source de silicium distinctes, sous un vide poussé, en les portant à une température suffisante pour provoquer leur évaporation et

traitement thermique approprié pour obtenir ledit siliciure.

2. Procédé selon la revendication 1 caractérisé en ce que ladite vaporisation simultanée est effectuée en utilisant comme source de chaleur un faisceau électronique pour évaporer le silicium et un autre faisceau électronique pour évaporer le métal.

3. Procédé selon la revendication 1 ou 2 caractérisé en ce que le traitement thermique du substrat implique de porter ce dernier à une température comprise approximativement entre 700 °C et 1 100 °C, dans une atmosphère inerte choisie dans le groupe comprenant : l'hydrogène, l'argon, l'hélium et les mélanges de ces gaz.

4. Procédé selon l'une des revendications ci-dessus, caractérisé en ce que le substrat est choisi dans le groupe comprenant : le silicium polycristallin, et le silicium monocristallin.

5. Procédé selon l'une des revendications ci-dessus, caractérisé en ce que le métal réfractaire est choisi dans le groupe comportant le molybdène, le tantale, le tungstène, le rhodium, et les mélanges de ces métaux.

6. Procédé selon l'une quelconque des revendications 1 à 5, caractérisé en ce que le siliciure comprend de 60 à 25 % environ en poids atomique dudit métal et de 40 à 75 % environ en poids atomique de silicium respectivement.

7. Procédé selon la revendication 6, caractérisé en ce qu'il comporte en outre l'étape d'oxydation d'une partie de la couche de siliciure, selon la technique sèche-humide-sèche effectuée à une température variant entre approximativement 800 °C et 1 100 °C pendant un intervalle de temps variant approximativement entre 15 minutes et 1 heure.

**Claims**

1. A method for fabricating a silicide electrode on a substrate, where a refractory metal and silicon is deposited on a substrate, characterized in that it includes the following steps :

simultaneous sputtering of metal and of silicon from distinct metal and silicon sources in high vacuum, heating these sources to a temperature which is sufficient to cause evaporation, and

appropriate heat treatment for obtaining said silicide.

2. A method according to claim 1, characterized in that said simultaneous sputtering is performed by using an electron beam as a heat source to evaporate the silicon, and another electron beam to evaporate the metal.

3. A method according to claim 1 or 2, characterized in that the heat treatment of the substrate requires that the substrate be heated to a temperature ranging from about 700 °C to 1 100 °C in an inert atmosphere selected in the group including hydrogen, argon, helium and mixtures thereof.

4. A method according to any one of the preceding claims, characterized in that the substrate is selected from the group consisting of polycrystalline silicon and monocrystalline silicon.

5. A method according to any one of the preceding claims, characterized in that the refractory metal is selected from the group consisting of molybdenum, tantalum, tungsten, rhodium, and mixtures of these metals.

6. A method according to any one of claims 1 to 5, characterized in that the silicide consists of about 60 to 25 % by atomic weight of said metal and of 40 to 75 % by atomic weight of silicon respectively.

7. A method according to claim 6, characterized in that it furthermore includes the oxidation step of part of the silicide layer, according to the dry-wet-dry technique performed at a temperature varying between about 800 °C and 1 100 °C during a time interval varying between about 15 minutes and one hour.

**Ansprüche**

1. Verfahren zum Herstellen einer Silicidelektrode auf einem Substrat, bei dem ein feuerfestes Metall und Silicium auf dem Substrat abgeschieden werden, dadurch gekennzeichnet, daß es folgende Verfahrensschritte umfaßt :
gleichzeitiges Aufdampfen von Metall und Silicium aus getrennten Quellen im Hochvakuum, wobei dieselben auf eine genügend hohe Temperatur erhitzt werden, um das Verdampfen zu bewirken, und
eine zum Erhalt des Silicids geeignete Wärmebehandlung.

2. Verfahren nach Anspruch 1, dadurch gekennzeichnet, daß zum gleichzeitigen Aufdampfen als Wärmequelle für die Verdampfung des Silicids ein Elektronenstrahl und für die Verdampfung des Metalls ein weiterer Elektronenstrahl benutzt wird.

3. Verfahren nach Anspruch 1 oder 2, dadurch gekennzeichnet, daß die Wärmebehandlung des Substrats, um dieses auf eine Temperatur zwischen etwa 700 °C und 1 100 °C zu erhitzen, in einer inerten Atmosphäre aus der Gruppe von Wasserstoff, Argon, Helium und Mischungen dieser Gase vorgenommen wird.

4. Verfahren nach einem der vorhergehenden Ansprüche, dadurch gekennzeichnet, daß das Substrat aus der Gruppe von einkristallinem und polykristallinem Silicium gewählt wird.

5. Verfahren nach einem der vorhergehenden Ansprüche, dadurch gekennzeichnet, daß das feuerfeste Metall aus der Gruppe von Molybdän, Tantal, Wolfram, Rhodium und aus Mischungen dieser Metalle gewählt wird.

6. Verfahren nach einem der Ansprüche 1 bis 5, dadurch gekennzeichnet, daß das Silicid ungefähr 60 bis 25 Atom-Gew.% dieses Metalls bzw. 40 bis 75 Atom-Gew.% Silicium enthält.

7. Verfahren nach Anspruch 6, dadurch gekennzeichnet, daß es außerdem die Oxidation eines Teils der Silicidschicht umfaßt, die nach der Trocken-Naß-Trockentechnik bei einer Temperatur zwischen ungefähr 800 °C und 1 100 °C während einer Zeitspanne von ungefähr 15 Minuten bis zu 1 Stunde durchgeführt wird.

FIG IA

4
3
2
1

FIG IB

5
4
3
6
2
7
8
1

FIG 2A

14
14
14
13
14
11
12

FIG 2B

15
14
16
16
12
12
11

FIG 2C

17
18
14
16
12
11

1

FIG 3A

FIG 3B

0 000 317

FIG 4A

EPAISSEUR OXYDE Å — TEMPS D'OXYDATION EN MINUTES

1000°C, 950°C, 900°C, 825°C

MOSi$_2$

FIG 4B

RESISTANCE DE COUCHE Ω/□ — TEMPS D'OXYDATION EN MINUTES

1000°C, 825°C, 900°C, 950°C

MOSi$_2$